# FASCICULE DE BREVET EUROPEEN

(11) **EP 1 610 463 B1**
(45) Date de publication et mention de la délivrance du brevet: **11.11.2009**
(21) Numéro de dépôt: 05105576.2
(22) Date de dépôt: 22.06.2005
(51) Int. Cl.: H03K 3/84

(54) **Vérification d'un flux de bits**
Verifikation eines Bitstromes
Verification of a bit stream

(30) Priorité: 24.06.2004 FR 0451325
(43) Date de publication de la demande: 28.12.2005
(73) Titulaire: STMicroelectronics S.A., 92120 Montrouge (FR)
(72) Inventeur: Liardet, Pierre-Yvan, 13790, Peynier (FR); Teglia, Yannick, 13011, Marseille (FR)
(74) Mandataire: de Beaumont, Michel

(56) Documents cités:
- US-A- 4 176 399
- US-A- 4 853 884
- US-A1- 2002 080 965
- US-B1- 6 414 558

## Description

### Domaine de l'invention

La présente invention concerne le domaine des générateurs de nombres aléatoires et plus précisément les générateurs de nombres aléatoires sous la forme de flux de bits issus d'une ou plusieurs sources de bruit, numériques ou numérisées.

### Exposé de l'art antérieur

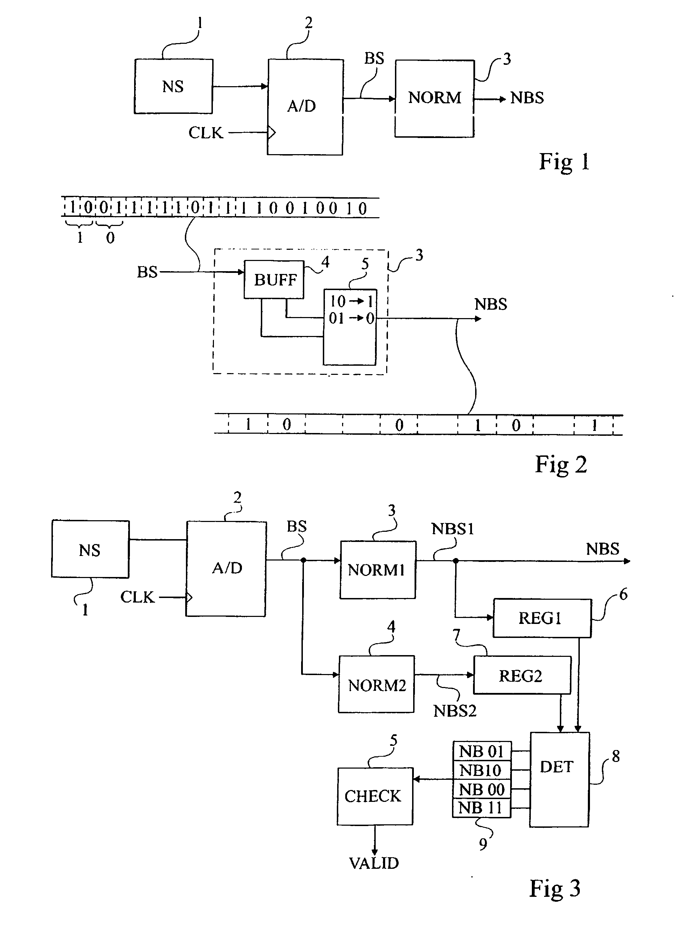

La figure 1, représente, de façon très schématique et sous forme de blocs, un exemple de générateur d'un flux de bits du type auquel s'applique la présente invention.

Un tel générateur comme décrit par exemple dans le US 4, 853,884 est basé sur l'utilisation d'une source de bruit 1 (NS) fournissant un bruit analogique à un élément 2 (A/D) de conversion analogique-numérique cadencé par exemple par une horloge CLK et fournissant un flux de bits BS. La source 1 est, par exemple, constituée d'un ou plusieurs oscillateurs dont les sorties sont sommées pour fournir un bruit analogique en entrée du convertisseur 2. Le convertisseur 2 peut, de façon simplifiée, être un inverseur associé à une bascule.

La qualité d'un générateur aléatoire ou plus généralement d'une source de bruit se mesure par la qualité de son aléa, ce qui a pour conséquence l'équiprobabilité des symboles fournis, par exemple l'équiprobabilité de 0 et de 1 dans le cas où l'on considère la source bit à bit.

En pratique, le flux BS fourni par le convertisseur 2 a des risques de ne pas avoir une répartition équiprobable de ses éléments (bits ou mots de bits). En particulier, la source de bruit 1 utilise généralement des oscillateurs pour lesquels il existe un risque de synchronisation entre eux ou avec l'horloge CLK. En cas de synchronisation, l'état fourni en sortie (flux de bits) est périodique.

Pour améliorer le caractère équiprobable d'un flux de bits censé être aléatoire, le flux BS traverse un circuit 3 de normalisation (NORM) fournissant un train de bits NBS modifié et dont l'équirépartition des 0 et des 1 dans le flux est améliorée.

La figure 2 représente un exemple classique de circuit 3 de normalisation d'un flux de bits BS appliquant une méthode dite de Von Neumann. Un tel circuit 3 est basé sur une analyse du flux de bits entrant BS, par paires de bits. On utilise alors un élément de mémorisation 4 (BUFF) permettant de traiter les bits, par paires, dans un circuit 5 de détermination d'état qui fournit le flux de bits normalisé NBS. D'après la méthode de Von Neumann, si la paire de bits est 1-0, on génère un état 1. Si la paire de bits est 0-1, on génère un état 0. Si la paire de bits est 0-0 ou 1-1, on l'ignore, c'est-à-dire qu'aucun état n'est généré en sortie. D'autres méthodes de normalisation existent appliquant ou non la méthode de Von Neumann.

Un deuxième exemple de normalisation consiste à calculer un bit de parité sur une longueur prédéterminée de la source et à exploiter uniquement ce bit de parité. Cette méthode a été décrite dans le document RFC 1750 en décembre 1994.

En principe, le nombre d'apparitions de 0 et de 1 dans le flux BS est constant, ce qui signifie que le biais (skew) - ou la dérive - de la source de bruit est constante au cours du temps. En effet, si cette propriété n'est pas respectée côté source de bruit, le circuit de normalisation n'a pas l'effet escompté de supprimer cette dérive dans le flux de bits.

L'efficacité d'un circuit de normalisation d'un flux de bits censé être aléatoire est particulièrement importante dans la mesure où les nombres aléatoires sont souvent utilisés dans des applications de chiffrement ou analogues pour lesquels la perte du caractère aléatoire du nombre constitue une faiblesse.

Un inconvénient des générateurs normalisés de nombres aléatoires actuels est qu'on ne sait pas vérifier l'élimination d'un biais éventuel par le circuit de normalisation. Cela vient notamment du fait que les méthodes de normalisation ne fonctionnent qu'en supposant, a priori, que le biais de la source de bruit est constant.

Un premier problème est que si ce biais devient non constant, le flux de bits fourni par le circuit de normalisation ne respecte plus l'équirépartition souhaitée sans que l'on s'en aperçoive.

Un deuxième problème est qu'une équirépartition sur un grand nombre de bits pourrait se vérifier a posteriori en sortie d'un circuit de normalisation, mais que l'on ne sait pas aujourd'hui vérifier dynamiquement ce caractère équiprobable pour détecter rapidement une éventuelle perte de constance du biais dans la source de bruit.

La présente invention vise à vérifier la constance du biais d'un flux de bits fourni par un circuit de normalisation et, en particulier, à détecter dynamiquement une dérive.

La présente invention vise également à proposer une solution compatible avec des méthodes de normalisation classiques et qui, notamment, ne requiert aucune modification de la génération du flux de bits aléatoire en elle-même.

L'invention vise également à proposer une solution de mise en oeuvre simple.

### Résumé de l'invention

Pour atteindre ces objets ainsi que d'autres, la présente invention prévoit un circuit de génération d'un flux de bits à partir d'une source de bruit et d'au moins un premier élément de normalisation du flux de bits initial fourni par cette source de bruit, comportant :
au moins un deuxième élément de normalisation de la même source de bruit, de nature différente par rapport au premier élément ; et
des moyens pour apparier, bit à bit, les flux issus des deux éléments ; et
des moyens pour vérifier l'équirépartition des quatre paires d'états possibles dans les paires de bit constituées, chacune d'un bit de chaque élément.

Selon un mode de réalisation de la présente invention, les éléments de normalisation sont choisis pour qu'il existe, sur deux ensembles de bits de même taille, au moins une valeur d'entrée pour laquelle les deux éléments fournissent un état différent, à une permutation bijective près.

Selon un mode de réalisation de la présente invention, les sorties respectives des éléments sont envoyées dans des registres à décalage dont les tailles sont choisies en fonction de la différence de débit entre les deux éléments de normalisation.

Selon un mode de réalisation de la présente invention, les moyens pour vérifier l'équirépartition comprennent quatre compteurs des occurrences respectives des quatre paires possibles de bits.

Selon un mode de réalisation de la présente invention, le circuit fournit un bit de validation du caractère équiprobable du flux de sortie tant que lesdites paires sont équiréparties.

L'invention prévoit également un procédé de détection d'une éventuelle perte de caractère équiprobable d'un premier flux de bits de sortie issu d'au moins un premier élément de normalisation d'un flux de bits initial, consistant à :
soumettre le flux initial à au moins un deuxième élément de normalisation de nature différente du premier ;
apparier, bit à bit, les flux issus des deux éléments ; et
vérifier l'équirépartition des paires d'états différentes.

Selon un mode de mise en oeuvre de la présente invention, les éléments de normalisation sont choisis pour qu'il existe, sur deux ensembles de bits de même taille, au moins une valeur d'entrée pour laquelle les deux éléments fournissent un état différent, à une permutation bijective près.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ; et
la figure 3 représente, de façon très schématique et sous forme de blocs, un mode de réalisation d'un circuit de validation du caractère aléatoire d'un flux de bits selon la présente invention.

### Description détaillée

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les détails constitutifs des circuits de normalisation, des convertisseurs analogique-numériques et de la source de bruit n'ont pas été exposés, l'invention étant compatible avec n'importe quelle réalisation classique.

Selon la présente invention, on valide le caractère équiprobable du flux de bits fourni par un circuit de normalisation, en vérifiant les nombres respectifs de paires de bits différentes (00, 11, 10 et 01) obtenues en appariant, bit à bit, ce flux et celui généré par un autre circuit de normalisation parallèle. En d'autres termes, on prévoit de traiter le flux de bits fourni par un convertisseur analogique-numérique par deux circuits de normalisation en parallèle, puis d'apparier les bits fournis par ces deux flux, afin de vérifier que le biais de la source de bruit d'entrée est bien constant. En fait, cela revient à vérifier l'équirépartition des états 11, 00, 01 et 10 dans les paires résultantes de l'appariement des deux flux de bits.

Selon l'invention, les deux circuits de normalisation sont choisis pour être différents l'un de l'autre, c'est-à-dire pour que les deux circuits fournissent, pour un même flux d'entrée, deux flux de sortie différents l'un de l'autre. Selon l'invention, deux circuits de normalisation sont de nature différente l'un de l'autre s'il existe, sur deux ensembles de même taille, au moins une valeur d'entrée pour laquelle les deux circuits fournissent un état différent, à une permutation bijective près.

La figure 3 représente, de façon très schématique et sous forme de blocs, un mode de réalisation d'un circuit de génération d'un flux de bits aléatoire mettant en oeuvre la présente invention.

Comme précédemment, une source de bruit par exemple analogique 1 (NS) fournit à un convertisseur 2 (A/D) un signal analogique qui, en étant par exemple échantillonné par un signal d'horloge CLK, devient un train de bits BS.

Selon ce mode de réalisation de l'invention, le flux BS est envoyé, en parallèle, sur un premier circuit 3 (NORM1) de normalisation fournissant un premier flux de bits normalisé NBS1 et sur un deuxième circuit 4 (NORM2) de normalisation fournissant un deuxième flux de bits normalisé NBS2.

Les circuits de normalisation 3 et 4 peuvent mettre en oeuvre n'importe quel procédé de normalisation classique (Von Neumann ou autre) pourvu d'être de nature différente au sens de l'invention. Par contre, ils peuvent avoir indifféremment des débits identiques ou différents.

Par exemple, un premier élément de normalisation traite les bits par paires et fournit un 1 pour chaque paire 1-0 et un 0 pour chaque paire 0-1 sans changer les états des autres paires. Un deuxième élément de normalisation traite les bits par triplets et fournit un 1 pour chaque triplet 1-0-1 et un 0 pour chaque triplet 0-1-1 sans changer les états des autres triplets. Dans ce cas, les éléments ont des débits différents l'un de l'autre.

Selon un autre exemple où les circuits ont des débits identiques, un premier élément de normalisation traite les bits du flux entrant par paires successives et les combine par une fonction OU-Exclusif (XOR). Un deuxième élément attribue, comme dans un normalisateur de Von Neumann, les états 0 et 1 (ou inversement) respectivement aux paires 01 et 10, et à l'apparition d'un doublon 00 ou 11, un état 1 si le bit de sortie déterminé par la paire précédente était 0 et un état 0 dans le cas contraire.

Selon l'invention, les flux fournis par les deux éléments 3 et 4 sont mémorisés temporairement pour permettre leur appariement. Par exemple, les flux NBS1 et NBS2 sont envoyés dans des registres 6 et 7 (par exemple, des registres à décalage REG1 et REG2). A chaque fois que les deux éléments 3 et 4 ont fourni un nouveau bit dans le flux, les deux bits sont appariés (bloc 8, DET) et sont comparés à l'une des quatre paires possibles (00, 01, 10, 11). Le détecteur 8 incrémente alors un compteur (compteurs 9 : NB00, NB01, NB10, NB11) affecté au nombre d'occurrences de chacune des paires. Les valeurs des compteurs 9 sont périodiquement comparées les unes aux autres (bloc 5, CHECK) pour vérifier qu'elle ne s'écartent pas les unes des autres. En effet, si les paires sont équiréparties, cela signifie que la source de bruit a un biais constant. Selon un exemple de réalisation, le bloc 5 fournit un bit d'état VALID indicateur du caractère équiprobable des flux NBS1 et NBS2.

En pratique, on vérifie périodiquement que les compteurs 9 ont des valeurs qui ne s'écartent pas trop les unes des autres, c'est-à-dire restent dans une plage prédéterminée considérée comme acceptable. Par exemple, à chaque comparaison, les valeurs de tous les compteurs sont normalisées par rapport à la valeur médiane des compteurs (qui ont tous la même taille) et on considère qu'un débordement d'un quelconque des compteurs signifie une perte du caractère équiprobable du flux de bits. Le choix de la taille des compteurs dépend de la taille de la tolérance souhaitée dans l'examen de l'équirépartition et de la périodicité des comparaisons.

La taille des registres 6 et 7 dépend de la différence de débit moyen entre les éléments 3 et 4.

Si les débits des éléments 6 et 7 sont constants et identiques, des registres d'un bit suffisent.

Si les débits moyens sont identiques mais non constants, les registres 6 et 7 ont des tailles identiques et doivent pouvoir stocker un nombre de bits correspondant au décalage temporel maximum possible dans des flux NBS1 et NBS2. Comme les débits sont identiques, ce sera tantôt l'un ou l'autre des registres 6 et 7 qui stockera le flux devant attendre l'autre pour l'appariement.

Si les débits moyens sont différents l'un de l'autre, c'est toujours le même registre 6 ou 7 qui sert à stocker le flux devant attendre l'autre. Dans ce cas, il est nécessaire de prévoir une réinitialisation périodique de ce registre.

En variante, on utilise deux compteurs par paire possible (huit compteurs au total) et on démarre l'incrémentation d'un compteur quand l'autre compteur affecté à la même paire est à sa valeur médiane. Chaque compteur est réinitialisé quand l'autre compteur affecté à la même paire a pris le relais du comptage des occurrences.

Si les occurrences des paires obtenues par appariement bit à bit des deux flux restent distribuées de façon équilibrée (dans la plage prédéterminée), cela signifie que les deux circuits de normalisation modifient le flux d'entrée BS en maintenant le biais de la source de bruit constant et, par conséquent, que n'importe lequel des flux des bits NBS1 et NBS2 fournis en sortie a un caractère équiprobable. Dans l'exemple de la figure 3, c'est le flux du premier normalisateur NBS1 qui fournit le flux NBS du générateur aléatoire.

Par contre, si la source de bruit 1 a un biais non constant, les deux circuits de normalisation vont modifier le flux de bits mais, comme ils sont de nature différente, sans modifier le caractère non constant du flux d'entrée BS. Par conséquent, la distribution des paires appariées des deux flux ne reste pas la même pour chaque paire.

Selon un exemple particulier de réalisation, on prévoit une période d'examen des compteurs 9 de 32 bits.

L'exploitation du résultat du bloc 5 dépend de l'application. Par exemple, si un compteur déborde, le flux de bits généré n'est pas utilisé car cela signifie qu'il n'est pas équiréparti de façon satisfaisante.

Bien entendu, la présente invention est susceptible de diverses variantes et modifications qui apparaîtront à l'homme de l'art. En particulier, le choix du circuit de normalisation à utiliser dépend de l'application qui peut conditionner l'utilisation d'un type de circuit de normalisation plutôt qu'un autre.

De plus, la réalisation pratique de l'invention, que ce soit par des moyens matériels et/ou logiciels, est à la portée de l'homme du métier à partir des indications fonctionnelles données ci-dessus.

En outre, bien que l'invention ait été décrite en relation avec un circuit de normalisation de type Von Neumann exploitant des paires de bits, elle s'applique plus généralement quelle que soit la longueur (paire ou impaire) des mots ou tronçons de flux entrants considérés par les circuits de normalisation. Par exemple, les bits entrants peuvent être traités quatre par quatre.

## Revendications

1. Circuit de génération d'un flux de bits (NBS) à partir d'une source de bruit (1) et d'au moins un premier élément (3) de normalisation du flux de bits initial (BS) fourni par cette source de bruit, **caractérisé en ce qu'**il comporte :
au moins un deuxième élément (4) de normalisation de la même source de bruit (1), de nature différente par rapport au premier élément (3) ; et
des moyens (8) pour apparier, bit à bit, les flux issus des deux éléments ; et
des moyens (5, 9) pour vérifier l'équirépartition des quatre paires d'états possibles dans les paires de bit constituées, chacune d'un bit de chaque élément.

2. Circuit selon la revendication 1, dans lequel les éléments de normalisation (3, 4) sont choisis pour qu'il existe, sur deux ensembles de bits de même taille, au moins une valeur d'entrée pour laquelle les deux éléments fournissent un état différent, à une permutation bijective près.

3. Circuit selon la revendication 1 ou 2, dans lequel les sorties respectives des éléments (3, 4) sont envoyés dans des registres à décalage (6, 7) dont les tailles sont choisies en fonction de la différence de débit entre les deux éléments de normalisation.

4. Circuit selon l'une quelconque des revendications 1 à 3, dans lequel les moyens pour vérifier l'équirépartition comprennent quatre compteurs (9) des occurrences respectives des quatre paires possibles de bits.

5. Circuit selon l'une quelconque des revendications 1 à 4, fournissant un bit (VALID) de validation du caractère équiprobable du flux de sortie (NBS) tant que lesdites paires sont équiréparties.

6. Procédé de détection d'une éventuelle perte de caractère équiprobable d'un premier flux de bits de sortie (NBS1) issu d'au moins un premier élément de normalisation (3) d'un flux de bits initial (BS), **caractérisé en ce qu'**il consiste à :
soumettre le flux initial (BS) à au moins un deuxième élément de normalisation (4) de nature différente du premier ;
apparier (8), bit à bit, les flux issus des deux éléments ; et
vérifier (5, 9) l'équirépartition des paires d'états différents.

7. Procédé selon la revendication 6, dans lequel les éléments de normalisation (3, 4) sont choisis pour qu'il existe, sur deux ensembles de bits de même taille, au moins une valeur d'entrée pour laquelle les deux éléments fournissent un état différent, à une permutation bijective près.

## Claims

1. A circuit for generating a bit flow (NBS) based on a noise source (1) and on at least one first element (3) for normalizing the initial bit flow (BS) provided by this noise source, **characterized in that** it comprises:
at least one second element (4) of normalization of the same noise source (1), of a different nature than the first element (3); and
means (8) for pairing, bit to bit, the flows originating from the two elements; and
means (5, 9) for checking the equidistribution of the four possible state pairs in the bit pairs, each formed of one bit of each element.

2. The circuit of claim 1, wherein the normalization elements (3, 4) are selected so that there exists, over two sets of bits of same size, at least one input value for which the two elements provide a different state, to within one bijective permutation.

3. The circuit of claim 1 or 2, wherein the respective outputs of the elements (3, 4) are sent to shift registers (6, 7) having sizes selected according to the flow rate difference between the two normalization elements.

4. The circuit of any of claims 1 to 3, wherein the means for checking the equidistribution comprise four counters (9) of the respective occurrences of the four possible bit pairs.

5. The circuit of any of claims 1 to 4, wherein the circuit provides a bit (VALID) for validating the equiprobable character of the bit flow (NBS) as long as said pairs are equidistributed.

6. A method for detecting a possible loss of the equiprobable character of a first output bit flow (NBS1) originating from at least one first element (3) of normalization of an initial bit flow (BS), **characterized in that** it consists of:
submitting the initial flow (BS) to at least one second normalization element (4) of a nature different from the first one;
pairing (8), bit to bit, the flows originating from the two elements; and
checking (5, 9) the equidistribution of pairs of different states.

7. The method of claim 6, wherein the normalization elements (3, 4) are selected so that there exists, over two sets of bits of same size, at least one input value for which the two elements provide a different state, to within one bijective permutation.

## Patentansprüche

1. Ein Schaltkreis zum generieren eines Bitflusses (NBS) basierend auf einer Rauschquelle (1) und auf wenigstens einem ersten Element (3) zum Normalisieren des anfänglichen Bitflusses (BS),der von dieser Rauschquelle vorgesehen ist, **gekennzeichnet dadurch, dass** er folgendes aufweist:
Wenigstens ein zweites Element (4) zur Normalisierung der gleichen Rauschquelle (1), von einer unterschiedlichen Natur als das erste Element (3); und
Mittel (8) zum bitweise anordnen der Flüsse, die von den zwei Elementen ausgehen; und
Mittel (5, 9) zum Prüfen der Gleichverteilung der vier möglichen Zustandspaare in den Bit - Paaren, wobei jedes gebildet ist aus einem Bit von jedem Element.

2. Schaltkreis nach Anspruch 1, wobei die Normalisierungselemente (3, 4) ausgewählt werden, so dass über zwei Sätze von Bits der gleichen Größe wenigstens ein Eingabewert existiert, für den die zwei Elemente einen unterschiedlichen Zustand vorsehen, und zwar in bis zu einer bijektiven bzw. eineindeutigen Permutation.

3. Schaltkreis nach Anspruch 1 oder 2, wobei die entsprechenden Ausgaben der Elemente (3, 4) zu Schieberegistern (6, 7) gesendet werden, die Größen haben ausgewählt gemäß des Flussratenunterschieds zwischen den zwei Normalisierungselementen.

4. Schaltkreis nach einem der Ansprüche 1 bis 3, wobei die Mittel zum Prüfen der Gleichverteilung vier Zähler (9) der entsprechenden Auftretungen der vier möglichen Bit-Paare aufweist.

5. Schaltkreis nach einem der Ansprüche 1 bis 4, wobei der Schaltkreis ein Bit (VALID) zum Validieren des gleichwahrscheinlichen Charakters des Bitflusses (NBS) vorsieht, solange die Paare gleichverteilt sind.

6. Ein Verfahren zum Detektieren eines möglichen Verlusts des gleichwahrscheinlichen Charakters eines ersten Ausgabebitflusses (NBS1), der von wenigstens einem ersten Element (3) von der Normalisierung eines anfänglichen Bitflusses (BS) ausgeht, **gekennzeichnet dadurch, dass** es aus dem Folgenden besteht:
Eingeben des anfänglichen Flusses (BS) zu wenigstens einem zweiten Normalisierungselement (4) mit einem natürlichen Unterschied zum dem ersten;
Bitweises Anordnen (8) der Flüsse ausgehend von den zwei Elementen; und
Prüfen (5, 9) der Gleichverteilung der Paare der unterschiedlichen Zustände.

7. Verfahren nach Anspruch 6, wobei die Normalisierungselemente (3, 4) ausgewählt werden, so dass über zwei Sätze von Bits der gleichen Größe wenigstens ein Eingabewert existiert, für den die zwei Elemente einen unterschiedlichen Zustand vorsehen, und zwar in bis zu einer bijektiven bzw. eineindeutigen Permutation.
